(19) Europäisches Patentamt
European Patent Office
Office européen des brevets

(11) **EP 4 783 393 A1**

(12) **EUROPEAN PATENT APPLICATION**

(43) Date of publication:
**29.07.2026 Bulletin 2026/31**

(21) Application number: **25153461.6**

(22) Date of filing: **23.01.2025**

(51) International Patent Classification (IPC):
*H02H 3/44* (2006.01)    *H02H 3/087* (2006.01)
*G01R 31/52* (2020.01)    *G01R 19/00* (2006.01)
*H02H 1/00* (2006.01)    *H02H 3/00* (2006.01)

(52) Cooperative Patent Classification (CPC):
**H02H 3/087; G01R 19/00; G01R 31/52;**
**H02H 1/0007; H02H 3/006; H02H 3/445**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **ABB S.p.A.**
**20124 Milano (IT)**

(72) Inventors:
• **GREGIS, Gioele**
  **24060 San Paolo d'Argon (BG) (IT)**
• **VILLAMIL PRIETO, Andres Enrique**
  **24124 Bergamo (IT)**

(74) Representative: **De Bortoli, Eros et al**
**Zanoli & Giavarini S.p.A.**
**Via Melchiorre Gioia, 64**
**20125 Milano (IT)**

(54) **A CURRENT DETECTION ARRANGEMENT FOR ELECTRIC GRIDS**

(57)    A detection arrangement for DC grids, characterized in that it comprises:
- a first detection module configured to detect a line current flowing along an Electric line and provide a first detection signal indicative of said line current;
- a second detection module configured to detect said line current along said Electric line and provide a second detection signal indicative of a magnitude variation rate over time of said line current;
- a plurality of signal processing modules to process said first and second detection signals and provide a detection signal indicative of the behaviour of said line current.

**FIG. 1**

**Description**

The present invention relates to the field of electric grids. More particularly, the present invention relates to a current detection arrangement for electric grids, which provides improved functionalities and greatly favors the implementation of fast disconnection procedures of portions of electric grid in case of fault events.

As known, when a fault event (such as a short-circuit) occurs in an electric line, many electrical components electrically connected to the electric line can feed such an electric fault. This may lead to catastrophic consequences, particularly when electric power generation systems (e.g., photovoltaic panels) or electric energy storage systems (e.g., batteries) are installed.

To prevent such an eventuality, an electric grid normally comprises protection devices configured in such a way to disconnect electric grid portions, whenever necessary. Typically, these protection devices include solid-state switches as these latter generally ensure a shorter switching time in comparison to electro-mechanical switches.

Normally, a protection device intervenes to interrupt an electric line upon receiving a trip signal provided by a suitable IED (Intelligent Electronic Device), for example a protection relay, operatively coupled to or included in the protection device. In turn, the above-mentioned IED includes or is operatively coupled to a current detection arrangement to monitor the behaviour of the line current flowing along the electric line.

As it is known, in modern electric grids, a current flowing along an electric line may be subject to sudden and strong raises (even in the order of thousands A/ms) when an electric fault (e.g., a short-circuit) occurs. Typically, line currents of this type may cause relevant damage to the electric loads fed by the electric line and to the solid-state switches included in a protection device operatively coupled to the electric line.

In view of the above, the market strongly requires that protection devices intervene to interrupt electric lines as quickly as possible and with high levels of accuracy to ensure a reliable circuit protection and, at the same time, prevent unnecessary service interruptions.

Unfortunately, this objective is difficult to achieve, nowadays.

In fact, detection arrangements currently employed in electric grids offer poor detection performances when line currents vary so fast.

In the state of the art, it is therefore still quite felt the need for innovative solutions, which allow a fast and reliable detection of currents in electric lines and are relatively simple and inexpensive to produce at industrial level.

In order to respond to this need, the present invention provides a current detection arrangement for electric grids, according to the following claim 1 and the related dependent claims. General characteristics and advantages of the invention will become apparent from the detailed description of exemplary embodiments of the invention, which is illustrated only by way of non-limitative examples in the accompanying drawings, wherein:

-    Figure 1 shows a block diagram of current detection arrangement, according to a general embodiment of the invention;
-    Figure 1A shows a block diagram of current detection arrangement, according to another embodiment the invention;
-    Figure 2 is a block diagram showing an example of intelligent electronic device including a current detection arrangement, according to the invention;
-    Figure 3 is a block diagram showing an example of intelligent electronic device operatively coupled to a current detection arrangement, according to the invention;
-    Figures 4-7 schematically show the operation of the current detection arrangement, according to the invention;
-    Figures 8-10 schematically show some examples of tripping curves set by an electronic device employing the current detection arrangement, according to the invention, to command a protection device operatively associated thereto.

With reference to the cited figures, the present invention relates to a current detection arrangement 1 for electric grids operating at low-voltage or medium-voltage levels.

Within the framework of the present invention, the term *"low voltage"* relates to operational voltages up to 1.5 kV DC (which may be extended even to 3 kV in certain applications) whereas the term *"medium voltage"* generally relates to operational voltages higher than 1.5 kV DC (or 3kV in certain applications) up to several tens of kV, e.g. up to 100 kV DC.

The current detection arrangement 1 of the invention is particularly adapted for use in DC electric grids and it will be described in the following with particular reference to these applications without intended to limit the scope of the invention in any way. The current detection arrangement 1 of the invention, in fact, may be advantageously used in AC electric grids.

In operation, the current detection arrangement 1 is operatively coupled to an electric line 100 (preferably a DC electric line) of an electric grid and is capable of providing improved detection functionalities of a line current I flowing along said electric line.

The electric line 100 may be arranged according to solutions of known type. Therefore, in the following, the electric line 100 will be described only with reference to the aspects of the invention for the sake of brevity.

As it will be apparent from the following description, the current detection arrangement 1 includes a plurality of detection modules 3, 4 and signal processing modules 5, 6, 7, 8, 9 configured to implement current detection functionalities. These modules are preferably implemented at industrial level in an analog manner. To this aim, each of the aforesaid modules can include electronic circuits (for example operational amplifying circuits) suitably designed to perform the foreseen functionalities. These electronic circuits may form stand-alone circuit units or be at least partially integrated one to another or in one or more circuit units. These electronic circuits may be realized on one or more printed circuit boards realized at industrial level through printed circuit manufacturing techniques of known type.

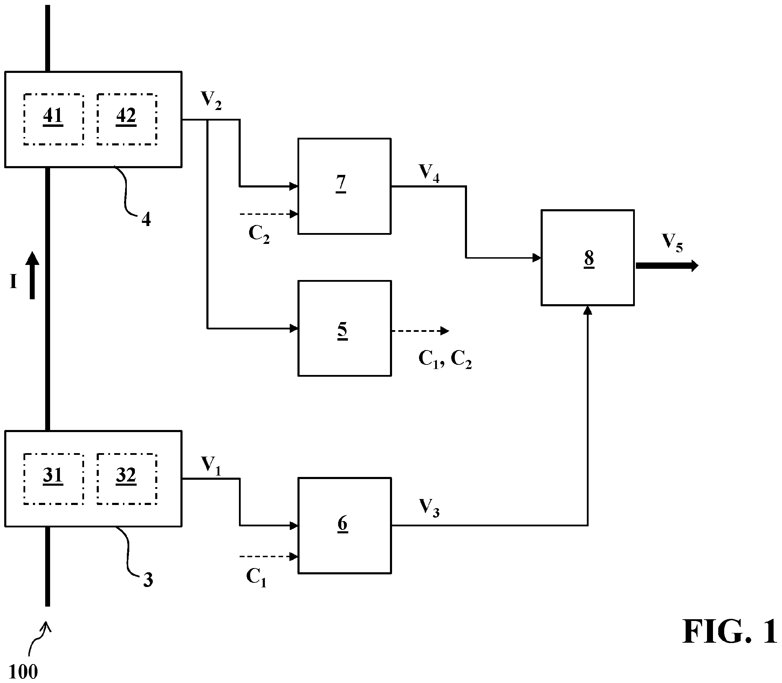

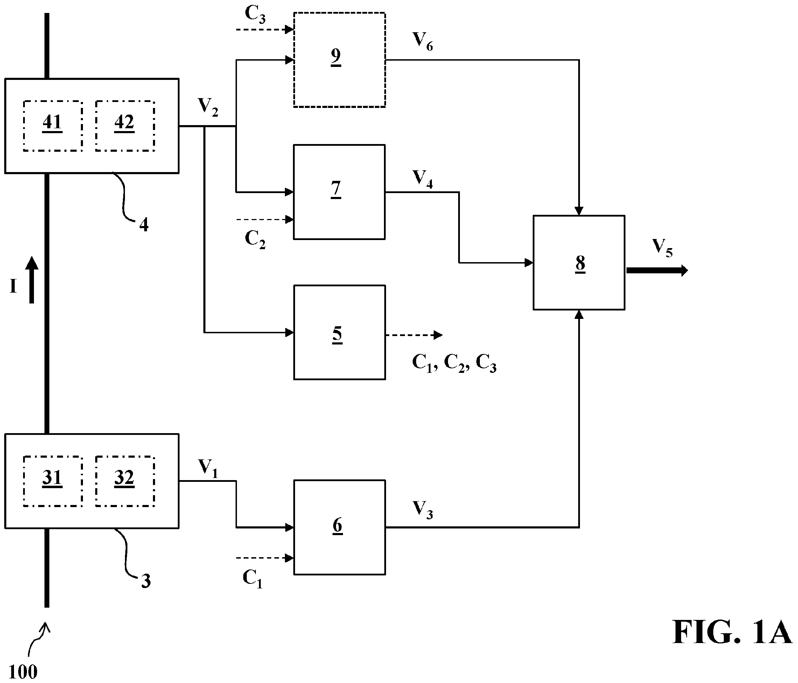

Reference is now made to figure 1 that shows the current detection arrangement 1 according to a general embodiment of the invention.

The current detection arrangement 1 comprises a first detection module 3 operatively coupled to the electric line 100, in use.

The first detection module is configured to detect a line current I, which flows along the electric line 100 and provides a first detection signal $V_1$ indicative of said line current.

The first detection signal $V_1$ is a signal variable in time depending on the magnitude of the detected line current I. In practice, the first detection signal $V_1$ describes the behaviour of the line current I over time.

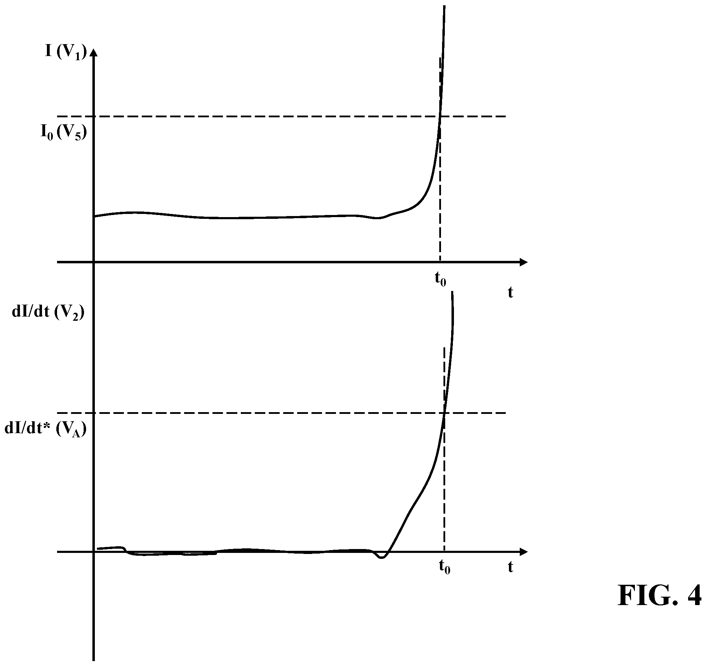

Figure 4 schematically represents the behaviour of the first detection signal $V_1$ as provided by the first detection module 1. As it is possible to notice, the first detection signal $V_1$ describes the behaviour of the line current I (more precisely of the magnitude of the line current) over time.

As it will be more apparent from the following, the first detection signal $V_1$ provided by the first detection module 3 can follow the behaviour of line current I only when this latter is subject to small or slow variations with respect to a nominal value.

Preferably, the first detection signal $V_1$ is a voltage signal in such a way to favour its processing by suitable signal processing resources 6, 8, 10 arranged in cascade to the first detection module.

Preferably, the first detection module 3 comprises a first sensing block 31 including one or more Hall-effect sensors or one or more shunt circuits operatively coupled to the one or more conductors of the electric line 100 in a known manner.

The first sensing block 31 can include suitable electronic circuits (e.g., operational amplifying circuits) to process (e.g., amplify and/or combine) the output signals provided by the above-mentioned current sensors operatively coupled to the electric line.

Preferably, the first detection module 3 comprises a first filtering block 32 electrically connected in cascade to the first sensing block 31.

The first filtering block 32 is conveniently configured to filter high-frequency spurious components of the output signal provided by the first sensing block 31.

The first filtering block 32 can include suitable electronic circuits (e.g., operational circuits) to implement a low pass filtering of the output signal provided by the first sensing block 31. The current detection arrangement 1 comprises a second detection module 4 operatively coupled to the electric line 100.

The second detection module 4 is configured to provide a second detection signal $V_2$ indicative of a variation rate *dI/dt* over time of the detected line current I.

The second detection signal $V_2$ is a signal variable in time depending on the magnitude variation rate over time of the line current. In practice, the second detection signal $V_2$ is indicative of the derivative over time of the line current I (if this latter is considered as a time-variable function). As it will be more apparent from the following, the second detection signal $V_2$ provided by the second detection module 4 can be used to determine the rate of change of the current I even when this latter is subject to quick variations with respect to a nominal value.

Figure 4 schematically represents the behaviour of the second detection signal $V_2$ as provided by the second detection module 4. As it is possible to notice, the second detection signal $V_2$ is the derivative over time of the first detection signal $V_1$. Therefore, it describes the behaviour of the variation rate dI/dt over time of the line current I.

Preferably, the second detection signal $V_2$ is a voltage signal in such a way to favour its processing by suitable signal processing resources 7, 8, 9, 10 arranged in cascade to the aforesaid second detection module 4.

Preferably, the second detection module 4 comprises a second sensing block 41 including a Rogowski coil operatively coupled to the one or more conductors of the electric line 100 in a known manner.

The third sensing block 41 can include suitable electronic circuits (e.g., operational circuits) to process (e.g., amplify and/or combine) the output signal provided by the Rogowski coil operatively coupled to the electric line.

Preferably, the second detection module 4 comprises a second filtering block 42 electrically connected in cascade to the second sensing block 41.

The second filtering block 42 is conveniently configured to filter high-frequency spurious components of the output signal received from the second sensing block 41.

The second filtering block 42 can include suitable electronic circuits (e.g., operational circuits) to implement a low pass filtering of the output signal provided by the second sensing block 41. The current detection arrangement 1 comprises a first signal processing module 5 operatively coupled to the second detection module 4 to receive and process the second detection signal $V_2$. The first signal processing module 5 is configured to control the operation of other signal processing modules 6, 7, 9 depending on the operating conditions of the electric line 100, which are conveniently determined based on the second detection signal $V_2$.

The first signal processing module 5 is configured to determine whether the electric line 100 operates in a normal condition or an abnormal condition based on the second detection signal $V_2$.

For the sake of clarity, it is specified that term *"normal condition"* refers to an operating condition of the electric line, in which there is detected a small variation or a slow variation of the line current I (more precisely of the magnitude thereof) compared to an expected nominal value. In this case, the electric line may be subject to no electric faults or to electric faults (e.g., overloads) in which the line current I raises slowly (for example in the order of tens A/ms). On the other hand, the term *"abnormal condition"* refers to an operating condition of the electric line, in which there is detected a relevant raising of the line current I (more precisely of the magnitude thereof) with respect to an expected nominal value. In this case, the electric line may be affected by electric faults (e.g., short-circuits), in which the line current I raises quickly (for example in the order of thousands A/ms).

Preferably, in operation, the first signal processing module 5 compares the second detection signal $V_2$ with a first threshold value $V_A$ indicative of a threshold variation rate *dI/dt\** set for the line current I (figure 4).

The first threshold value $V_A$ can be set depending on physical boundaries above which dangerous operating conditions are known to occur. Said boundaries are known for a given system and depend on several factors such as the characteristics of the electric line and the protection device, for example the equivalent inductance of the electric line, the turn off capability of the protection device, and the like.

Preferably, the first signal processing module 5 determines that the electric line 100 operates in a normal condition, if the second detection signal $V_2$ does not exceed the first threshold value $V_A$, and determines that the electric line 100 operates in an abnormal condition, if the second detection signal $V_2$ exceeds the first threshold value $V_A$.

The first signal processing module 5 is configured to provide control signals $C_1$, $C_2$, $C_3$ to control the operation of other signal processing modules 6, 7, 9. These control signals are conveniently generated depending on the operating conditions of the electric line 100 as determined by the first signal processing module 5. The above-mentioned control signals are thus indicative of the operating conditions of the electric line 100.

The deliver of the control signals $C_1$, $C_2$, $C_3$ by the first signal processing module 5 may occur according to several modes, according to the needs.

As an example, the control signals $C_1$, $C_2$, $C_3$ can be logic signals taking a *low* value (e.g., $\approx$ 0V), if the electric line 100 is determined to operate in a normal condition, and a *high* value (e.g., $\approx$ 3,3V), if the electric line 100 is determined to operate in an abnormal condition, or vice-versa.

As a further example, the first signal processing module 5 can send no control signals if the electric line 100 is determined to operate in a normal condition, and send a certain control signal $C_1$, $C_2$, $C_3$ (trigger signal) at a trigger instant $t_0$, when the electric line 100 is determined to operate in an abnormal condition (i.e., when a relevant rising of the magnitude of the line current is detected).

As a further example, the first signal processing module 5 can send a certain control signal $C_1$, $C_2$, $C_3$ (enabling signal) if the electric line 100 is determined to operate in a normal condition and stop sending such a control signal at a trigger instant $t_0$, when the electric line 100 is determined to operate in an abnormal condition.

The first signal processing module 5 may be easily designed to generate the control signals $C_1$, $C_2$, $C_3$ according to further alternative modes upon the determination of the operating conditions of the electric line 100.

The current detection arrangement 1 comprises a second signal processing module 6 operatively coupled to the first detection module 3 to receive and process the first detection signal $V_1$. The second signal processing module 6 is configured to provide in output a third detection signal $V_3$, which is generated based on the first detection signal $V_1$.

Preferably, also the third detection signal $V_3$ is a voltage signal in such a way to favour its processing by suitable signal processing resources 8, 10 arranged in cascade to the aforesaid second signal processing module.

The second signal processing module 6 is configured to provide a third detection signal $V_3$, which substantially tracks the first detection signal $V_1$ received from the first detection module 3, if a normal operating condition of the electric line 100 is determined by the first signal processing module 5.

In this case, the third detection signal $V_3$ is a signal variable in time depending on the magnitude of the line current I. In practice, the third detection signal $V_3$ is indicative of the line current I over time (as the first detection signal $V_1$).

The second signal processing module 6 is configured to provide a third detection signal $V_3$, which takes a constant value $V_S$, if an abnormal operating condition of the electric line 100 is determined by the first signal processing module 5.

In this case, the third detection signal $V_3$ is constant in time and takes a constant value $V_S$ indicative of a magnitude value $I_0$ of the line current I measured by the first detection module 3 at a trigger instant $t_0$, at which the first signal processing module 5 has determined that the electric line 100 operates in an abnormal condition.

The second signal processing module 6 is apparently configured to carry out signal track and hold functionalities depending on the operating conditions of the electric line 100, as determined by the first signal processing module 5.

The second signal processing module 6 carries out track functionalities if a normal condition of the electric line is determined by the first signal processing module 5 (i.e., before the trigger instant $t_0$). In this case, the third detection signal $V_3$ substantially tracks the first detection signal $V_1$.

The second signal processing module 6 carries out hold functionalities if an abnormal condition of the electric line is determined by the first signal processing module 5 (i.e., after the trigger instant $t_0$). In this case, the third detection signal $V_3$ takes the constant value $V_S$, which is taken by the first detection signal $V_1$ at the trigger instant $t_0$.

Advantageously, the second signal processing module 6 operates based on first control signals $C_1$ received from the first signal processing module 5.

As an example, the second signal processing module 6 can carry out the above-mentioned tracking functionalities, if it has not received any control signal from the first signal processing module 5, and can carry out the above-mentioned hold functionalities in response to receiving a control signal $C_1$ (trigger signal) indicating that the first signal processing module 5 has determined that the electric line 100 operates in an abnormal condition (trigger instant $t_0$, possible transmission delays are substantially negligible).

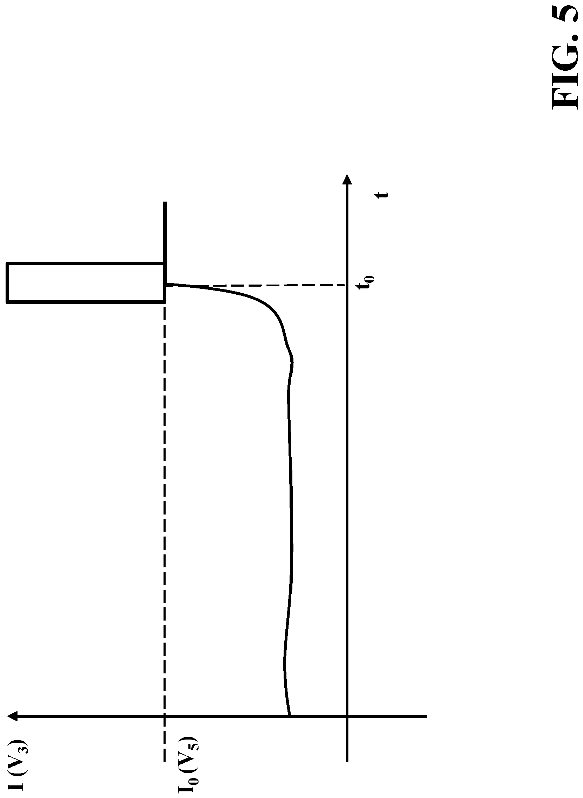

Figure 5 schematically represents the behaviour of the third detection signal $V_3$ as provided by the second signal processing module 6. As it is possible to notice, the third detection signal $V_3$ substantially follows the first detection signal $V_1$ (i.e., the magnitude of the line current I) at time instants preceding the trigger instant $t_0$ and takes a constant value $V_S$ (which is indicative of the magnitude value $I_0$ of the line current I measured by the first detection module 3 at the trigger instant $t_0$) at time instants following the trigger instant $t_0$.

The detection arrangement 1 comprises a third signal processing module 7 operatively coupled to the second detection module 4 to receive and process the second detection signal $V_2$.

The third signal processing module 7 is configured to provide in output a fourth detection signal $V_4$, which is generated based on the second detection signal $V_2$.

Preferably, also the fourth detection signal $V_4$ is a voltage signal to favour its processing by suitable signal processing resources 8, 10 arranged in cascade to the third signal processing module 7.

The third signal processing module 7 is configured to provide no detection signals (or a null detection signal), if a normal condition of the electric line 100 is determined by the first signal processing module 5. In practice, if a normal operating condition of the electric line is determined by the first signal processing module 5, the third signal processing module 7 does not operate.

The third signal processing module 7 is configured to provide the fourth detection signal $V_4$, if an abnormal operating condition of the electric line 100 is determined by the first signal processing module 5. Therefore, the third signal processing module 7 provides the fourth detection signal $V_4$ at time instants following the trigger instant $t_0$.

The fourth detection signal $V_4$ is obtained by integrating the second detection signal $V_2$ over time, starting from the trigger instant $t_0$.

As it is the result of the integration of a signal (the second detection signal $V_2$) indicative of the derivative over time of the line current I, the fourth detection signal $V_4$ is a signal variable in time depending on the magnitude of the line current I at time instants following the trigger instant $t_0$.

In practice, the fourth detection signal $V_4$ is indicative the line current I over time, at time instants following the trigger instant $t_0$.

The third signal processing module 7 is preferably configured to carry out an integration operation of the second detection signal $V_2$, if an abnormal operating condition of the electric line 100 is determined by the first signal processing module 5. In this case, the third signal processing module 7 starts operating (from a null-signal level) at the trigger instant $t_0$ and the fourth detection signal $V_4$ can be given by the following relation:

$$V_4(t) = \int_{t_0}^{t} V_2(t)dt$$

Advantageously, the third signal processing module 7 operates based on second control signals $C_2$ received from the first signal processing module 5.

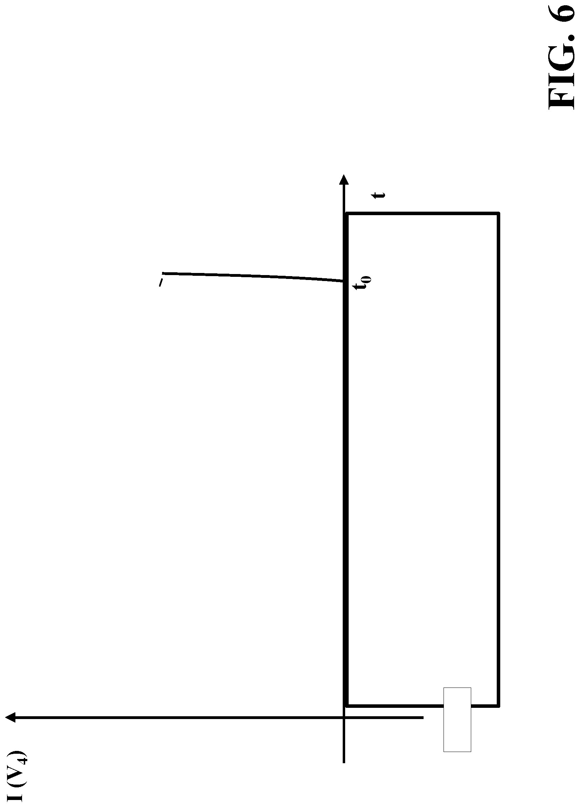

As an example, the third signal processing module 7 can remain in a stand-by state until it receives a control signal from the first signal processing module 5. In response to receiving a control signal $C_2$ (trigger signal), which indicates that the first signal processing module 5 has determined that the electric line 100 operates in an abnormal condition (trigger instant $t_0$, possible transmission delays are substantially negligible), the third signal processing module 7 start carrying out the above-mentioned integration operation (starting from a null signal level). Figure 6 schematically represents the behaviour of the fourth detection signal $V_4$ as provided by the fourth signal processing module 4. As it is possible to notice, the fourth detection signal $V_4$ describes the behaviour of the line current I at time instants following the trigger instant $t_0$. The detection arrangement 1 comprises a fourth signal processing module 8 operatively coupled to the second and third signal processing modules 6, 7 to receive and process the third and fourth detection signals $V_3$, $V_4$.

The fourth signal processing module 8 is configured to provide in output a fifth detection signal $V_5$, which is generated based on the above-mentioned detection signals $V_3$, $V_4$.

Preferably, also the fifth detection signal $V_5$ is a voltage signal in such a way to favour its processing by suitable signal processing resources 10, possibly arranged in cascade to the fourth signal processing module 8.

The fourth signal processing module 8 is configured to obtain the fifth detection signal $V_5$ by carrying out a weighted sum of the above-mentioned third and fourth detection signals $V_3$, $V_4$. In practice, the fifth detection signal $V_5$ can be calculated according to the following relation:

$$V_5(t) = k_1 V_3(t) + k_2 V_4(t)$$

where $k_1$, $k_2$ are weight coefficients that can be easily calculated based on the characteristics of the electronics (e.g., operational circuits) included in the current detection arrangement and of a threshold current value $I_{TH}$ set to command (trip signal) the interruption of the electric line 100.

Being the result of a weighted sum of the third and fourth detection signals $V_3$, $V_4$, the fifth detection signal $V_5$ is a signal variable in time depending on the magnitude of the line current I. In practice, the fifth detection signal $V_5$ describes the behaviour of the line current I over time.

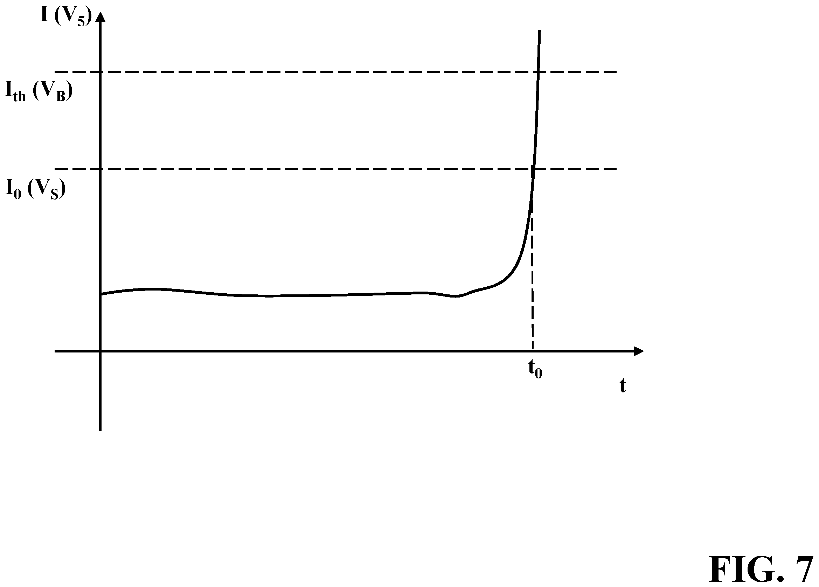

Figure 7 schematically represents the behaviour of the fifth detection signal $V_5$ as provided by the fourth signal processing module 8. As it is possible to notice:

- at time instants $t <= t_0$, the fifth detection signal $V_5$ describes the behaviour of the line current I at time instants by virtue of the contribution given by the third detection signal $V_3$. It is noted that at the instant $t = t_0$, the fifth detection signal $V_5$ takes the value $V_s$ indicative of the magnitude $I_0$ of the line current I as measured at the trigger instant $t_0$;
- at time instants $t > t_0$, the fifth detection signal $V_5$ describes the behaviour of the line current I by virtue of the contribution given by the fourth detection signal $V_4$.

In view of the above, it is apparent that the fifth detection signal $V_5$ can be expressed by the following relation:

$$V_5(t) = k_1 V_3(t) + k_2 V_4(t) = K_1 I(t_0) + K_2 \int_{t_0}^{t} \frac{dI}{dt}(t)dt$$

where $K_1$, $K_2$ are weight coefficients corresponding to the above-mentioned weight coefficients $k_1$, $k_2$. The weight coefficients $K_1$, $K_2$ can also be easily calculated based on the characteristics of the electronics included in the detection arrangement and the threshold current value $I_{TH}$ set for electric line 100.

An example of calculation of the weight coefficients $k_1$, $k_2$, $K_1$, $K_2$ is proposed in the following. It is supposed that the electronics of the detection arrangement 1 operates at $Vcc = \pm 5,0$ V and that a threshold current value $I_{TH} = 4$ kA is set to command (trip signal) the interruption of the electric line 100.

A threshold voltage value of Vs*=4,7V can be selected for the voltage signal $V_5$. The threshold voltage value $V_5$* is the value of the fifth detection signal $V_5$ (that describes the behaviour of the line current I), which corresponds to the above-mentioned threshold current value $I_{TH}$.

In this case, the weight coefficients $K_1$, $K_2$ can be calculated as:

$$K_1 = K_2 = V_5*/ I_{TH} = 4,7/4000 = 1,175 \ mv/A.$$

The weight coefficients $k_1$, $k_2$ can be calculated based on the weight coefficients $K_1$, $K_2$ as:

$$k_1 = k_2 = p_1 K_1 = p_2 K_2$$

where $p_1$, $p_2$ are proportionality factors that depends on the selected threshold current value $I_{TH}$. As an example, the proportionality factors $p_1$, $p_2$ can be calculated as:

$$p_1 = K_1/ G_1 = 1,175/5 = 0,235$$

$$p_2 = K_2/ G_2 = 1,175/5 = 0,235$$

where $G_1$, $G_2$ is the gain of the electronics of the detection arrangement 1 for the selected threshold current value $I_{TH}$ (in this case, it is arbitrarily assumed that $G_1=G_2 = 5$ *mv/A*).

As the skilled person can certainly understand, the weight coefficients $k_1$, $k_2$, $K_1$, $K_2$ can be calculated differently if the electronics included in the current detection arrangement operates differently and a different threshold current value $I_{TH}$ is set to command the interruption of the electric line 100.

As it is possible to notice, the fifth detection signal $V_5$ can be calculated according to the following relation till a normal condition is determined by the first processing module 3:

$$V_5(t) = k_1 V_3(t)$$

where $k_1$ is a coefficient that can be easily calculated based on the characteristics of the electronics (e.g., operational circuits) included in the current detection arrangement.

In this case, in fact, the third signal processing module 7 is not active (no abnormal condition is detected) and its output signal $V_4$ is virtually null.

In view of the above, the fifth detection signal $V_5$ can be expressed by the following relation:

$$V_5(t) = k_1 V_3(t) = K_1 I(t)$$

where $k_1$ is a coefficient corresponding to the above-mentioned coefficient $K_1$, which may be calculated as shown above.

According to other embodiments of the invention (figure 1A), the detection arrangement 1 comprises a fifth signal processing module 9 in addition to the signal processing modules 5, 6, 7, 8 described above with reference to the embodiments of figure 1.

The fifth signal processing module 9 is operatively coupled to the second detection module 4 to receive and process the second detection signal $V_2$.

The fifth signal processing module 9 is configured to provide in output a sixth detection signal $V_6$, which is generated based on the second detection signal $V_2$.

Preferably, also the sixth detection signal $V_6$ is a voltage signal to favour its processing by suitable signal processing resources 8, 10 arranged in cascade to the third signal processing module 7.

The fifth signal processing module 9 does not provide any detection signal (or a null detection signal), if a normal condition of the electric line 100 is determined by the first signal processing module 5. In practice, if a normal operating condition of the electric line is determined by the first signal processing module 5, the fifth signal processing module 9 does not operate.

The fifth signal processing module 9 is configured to provide the sixth detection signal $V_6$, if an abnormal operating condition of the electric line 100 is determined by the first signal processing module 5. Therefore, the fifth signal processing module 9 provides the sixth detection signal $V_6$ at time instants following the trigger instant $t_0$, at which the first signal processing module 5 has determined that the electric line 100 operates in an abnormal condition. The sixth detection signal $V_6$ is obtained by rescaling the second detection signal $V_2$, starting from the trigger instant $t_0$.

As it is the result of the amplification of a signal (the second detection signal $V_2$) indicative of the derivative over time of the line current I, the sixth detection signal $V_6$ is a signal variable in time depending on the variation rate of the magnitude of the line current I at time instants following the trigger instant $t_0$. In practice, the sixth detection signal $V_6$ is indicative the derivative of the line current I over time, at time instants following the trigger instant $t_0$.

It is noted that the sixth detection signal $V_6$ can be considered as taking a constant value, which is indicative of a constant variation rate of the magnitude of the line current I, if the line current I is reasonably considered as a ramp signal at time instants following the trigger instant $t_0$. Advantageously, the fifth signal processing module 9 operates based on third control signals $C_3$ received from the first signal processing module 5.

As an example, the fifth signal processing module 9 can remain in a stand-by state until it receives a control signal from the first signal processing module 5. In response to receiving a control signal $C_3$ (trigger signal), which indicates that the first signal processing module 5 has determined that the electric line 100 operates in an abnormal condition (trigger instant $t_0$, possible transmission delays are substantially negligible), the fifth signal processing module 9 can start carrying out the above-mentioned amplification functionalities.

According to the embodiment shown in figure 1A, the fourth signal processing module 8 of the current detection arrangement is operatively coupled to the second, third and fifth signal processing modules 6, 7, 9 to receive and process the third, fourth and sixth detection signals $V_3$, $V_4$, $V_6$.

The fourth signal processing module 8 is configured to provide in output a fifth detection signal $V_5$, which is generated based on the above-mentioned detection signals $V_3$, $V_4$, $V_6$.

Also in this case, the fifth detection signal $V_5$ is preferably a voltage signal.

The fourth signal processing module 8 is configured to obtain the fifth detection signal $V_5$ by carrying out a weighted sum of the above-mentioned third, fourth and sixth detection signals $V_3$, $V_4$, $V_6$.

In practice, the fifth detection signal $V_5$ can be calculated according to the following relation:

$$V_5(t) = k_1 V_3(t) + k_2 V_4(t) + k_0 V_6(t) = K_1 I(t_0) + K_2 \int_{t_0}^{t} \frac{dI}{dt}(t)dt + K_0 \frac{dI}{dt}(t)$$

where $k_1$, $k_2$, $k_0$, $K_1$, $K_2$, $K_0$ are weight coefficients corresponding to the above-mentioned weight coefficients $k_1$, $k_2$, $k_0$ that can be easily calculated similarly to the example described above. As it is possible to notice, the fifth detection signal $V_5$ can be calculated according to the following relation until a normal condition is determined by the first processing module 3:

$$V_5(t) = k_1 V_3(t)$$

where $k_1$ is a coefficient that can be easily calculated based on the characteristics of the electronics (e.g., operational circuits) included in the current detection arrangement.

In this case, in fact, the third and fifth signal processing modules 7, 9 are not active (no abnormal condition is detected) and their output signals $V_4$, $V_6$ are virtually null.

In view of the above, it is apparent that the fifth detection signal $V_5$ can be expressed by the following relation:

$$V_5(t) = k_1 V_3(t) = K_1 I(t)$$

where $K_1$ is a coefficient corresponding to the above-mentioned coefficient $k_1$.

In a further aspect, the present invention relates to an electronic device 50 for Electric grids. The electronic device 50 may be any kind of IED intended for use in Electric grids, for example a protection relay.

The electronic device 50 is configured to drive the operation of a protection device 110 operatively coupled to the electric line 100 to control the flow of a line current I along said electric line.

The protection device 110 can take a closed state, at which it allows the flow of the line current I along the electric line, and an open state, at which it allows the flow of the line current I along the electric line.

Preferably, the protection device 110 includes one or more solid-state switches and suitable driving electronics to drive said solid-state switches in such a way to cause reversable transitions of the protection device 110 between the above-mentioned operating states.

In general, the protection device 110 can be of the known type and it will here not be disclosed in further details for the sake of brevity. As an example, the protection device 110 can be a circuit breaker of the solid-state type or a circuit breaker of the hybrid type.

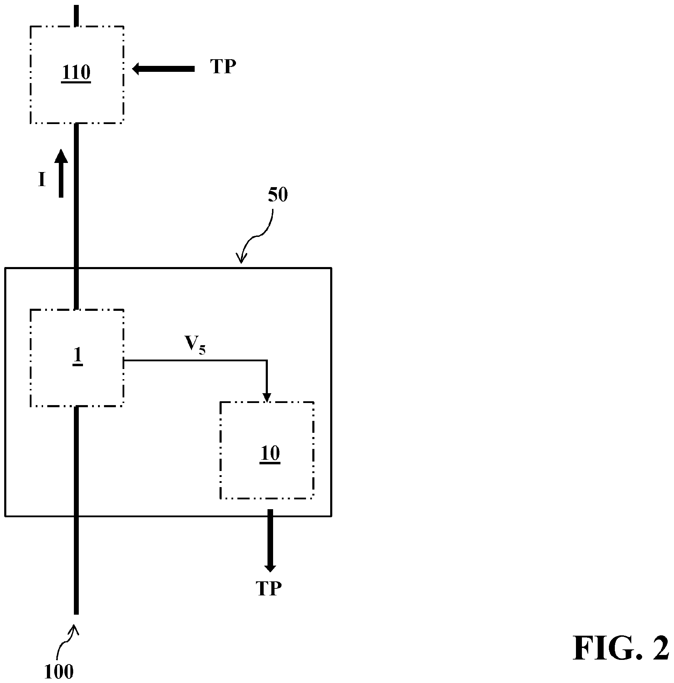

According to some embodiments (figure 2), the electronic device 50 includes the detection arrangement 1 of the invention as described above.

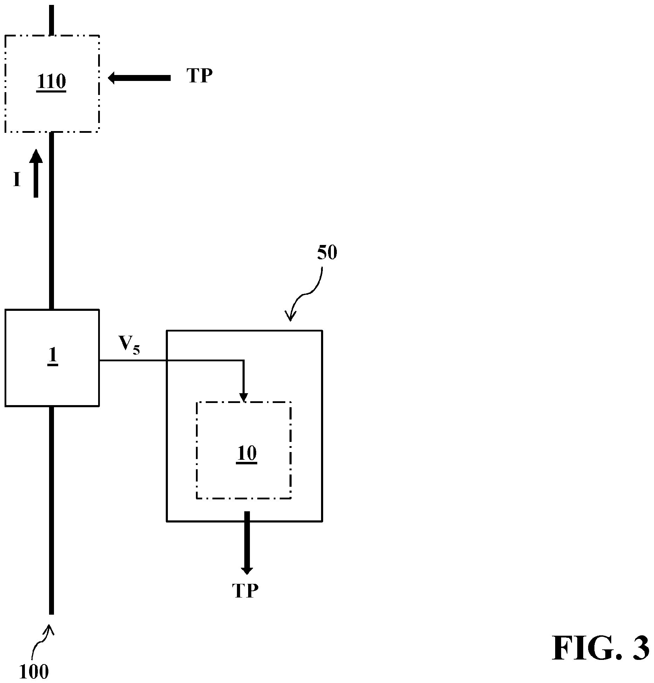

According to other embodiments (figure 3), the electronic device 50 is operatively coupled to the current detection arrangement 1 of the invention as described above.

Preferably, the electronic device 50 includes a signal processing stage 10 operatively coupled to the fourth signal processing module 8 of the current detection arrangement to receive and process the fifth detection signal $V_5$ provided in out by said signal processing module. Preferably, the signal processing stage 10 is configured to provide a trip signal TP for the protection device 110, in particular to command a transition of this latter from a closed state to an open state. The signal processing stage 10 is configured to generate the trip signal TP based on the fifth detection signal $V_5$ provided by the fourth signal processing module 8 of the current detection arrangement.

Preferably, the signal processing stage 10 is configured to compare the fifth detection signal $V_5$ with a second threshold value $V_B$ indicative of a threshold current value $I_{TH}$ set to command the interruption of the line current I flowing along the electric line (figure 7).

Preferably, the signal processing stage 10 is configured to provide in output the above-mentioned trip signal TP, if the fifth detection signal $V_5$ exceeds the second threshold value $V_B$.

According to an embodiment of the electronic device 50, the threshold current value $I_{TH}$ is constant, and it does not vary with the derivative $dI/dt$ of the line current I.

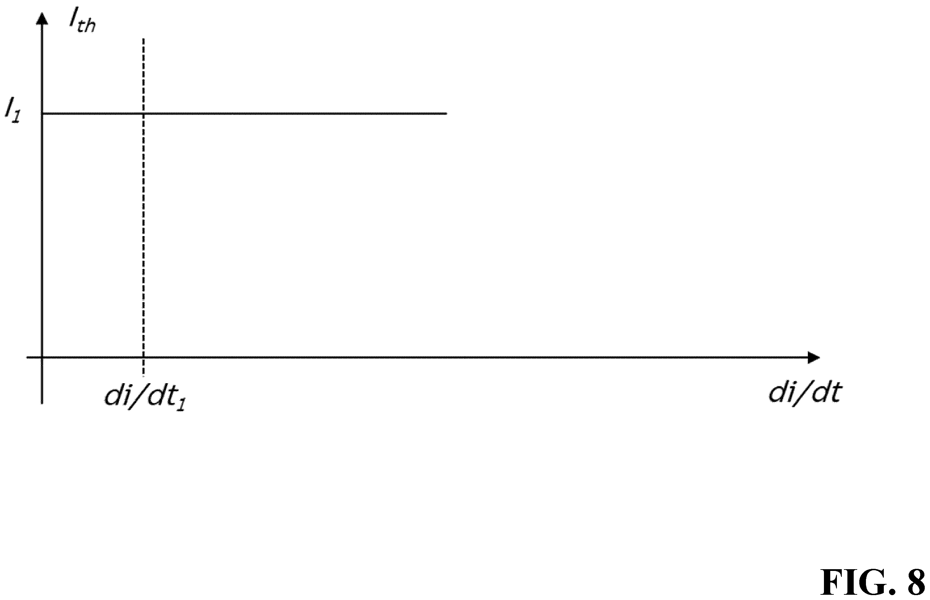

Figure 8 shows as example of a tripping curve set for the switching device 110 in accordance with this solution. As it is possible to notice, the threshold current value is set to $I_{TH} = I_1$ and it does not vary with the derivative $dI/dt$ of the line current I.

According to another embodiment of the electronic device 50, the threshold current value $I_{TH}$ can vary with the derivative $dI/dt$ of the line current I.

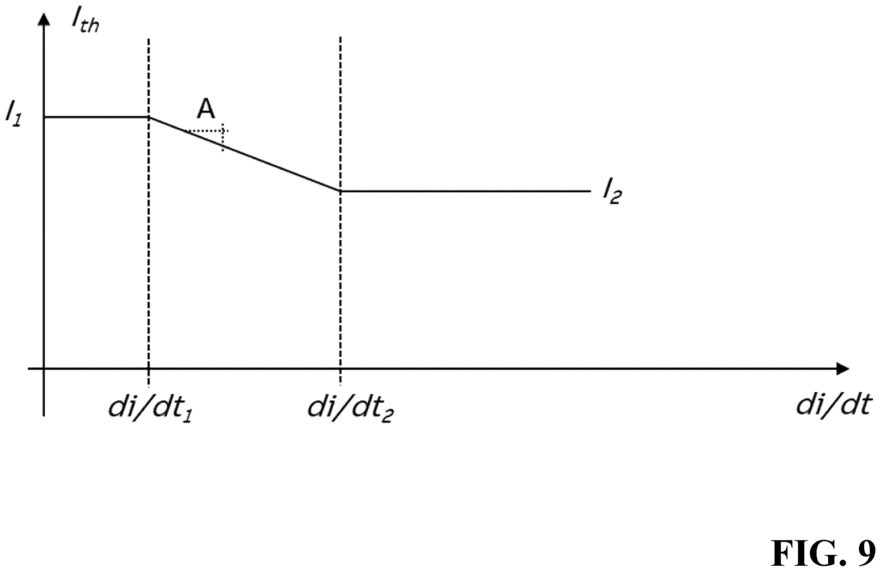

Figure 9 shows an example of a tripping curve set for the switching device 110 in accordance with this solution. As it is possible to notice, the threshold current value is set to:

- a first constant value $I_{TH} = I_1$, if the derivative of the line current I is lower than a first predefined derivative value $dI/dt_1$, which preferably coincides with the threshold variation rate $dI/dt*$ of the line current at the above-mentioned trigger instant $t_0$ (figure 4);
- a second constant value $I_{TH} = I_2 < I_1$, if the derivative of the line current I is higher than a second predefined derivative value $dI/dt_2$;
- a value variable with the derivative of the line current I for derivative values included in the range of values $dI/dt_1 <= dI/dt <= dI/dt_2$. In this case, the threshold current value $I_{TH}$ may belong to a line having a (negative) slope $A = (I_2 - I_1) / (dI/dt_2 - dI/dt_1)$.

This kind of tripping curve is particularly useful to drive a switching device 110 including solid-state switches (for example IGBTs) with a relatively high turn-off delay. In this case, it is safer to set the threshold current $I_{TH}$ at a lower level, when the line current I raises very fast $(dI/dt >= dI/dt_2)$ On the other, the threshold current $I_{TH}$ can be set at a higher level, when the line current I raises slowly $(dI/dt <= dI/dt_1)$.

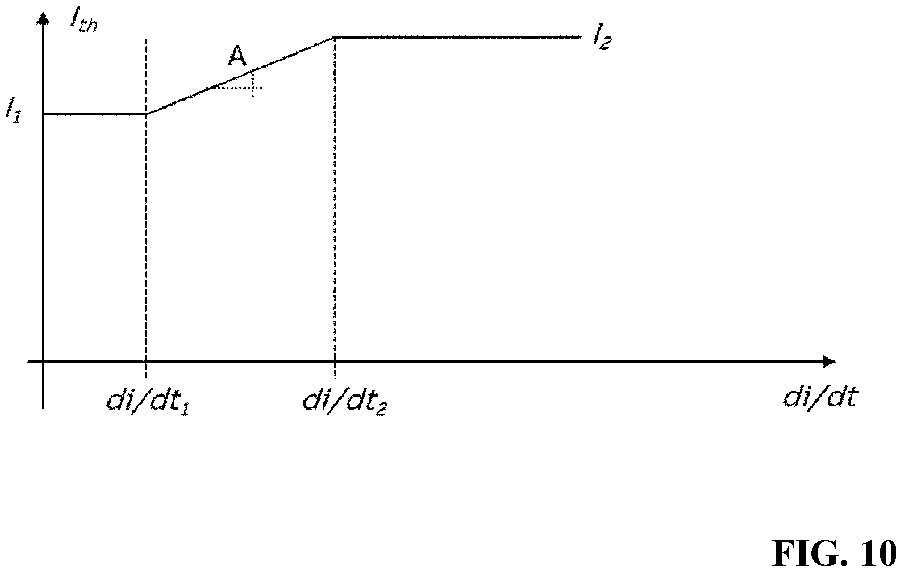

Figure 10 shows another example of a tripping curve set for the switching device 110 in accordance with the above-mentioned solution. As it is possible to notice, the threshold current $I_{TH}$ is set to:

- a first constant value $I_{TH} = I_1$, if the derivative of the line current I is lower than a first predefined derivative value $dI/dt_1$, which preferably coincides with the threshold variation rate $dI/dt*$ of the line current at the above-mentioned trigger instant $t_0$ (figure 4);
- a second constant value $I_{TH} = I_2 > I_1$, if the derivative of the line current I is higher than a second predefined derivative value $dI/dt_2$;
- a value variable with the derivative of the line current I for derivative values included in the range of values $dI/dt_1 <= dI/dt <= dI/dt_2$. In this case, the threshold current value $I_{TH}$ may belong to a line having a (positive) slope $A = (12 - I_1) / (dI/dt_2 - dI/dt_1)$.

This kind of tripping curve is particularly useful to drive a protection device 110 including solid-state switches (for example MOSFETs) with a relatively small turn-off energy capability. In this case, it is safer to set the threshold current $I_{TH}$ at a lower level, when the line current I raises slowly $(dI/dt <= dI/dt_1)$. On the other, the threshold current $I_{TH}$ can be set at a higher level, when the line current I raises fast $(dI/dt >= dI/dt_2)$.

In these last embodiments of the electronic device 50, the most appropriate threshold current value $I_{TH}$ value (in consideration of the characteristics of the solid-state switches of the protection device 110) can be dynamically selected based on the detection information provided by the detection arrangement 1.

Such a detection information includes, in general, the fifth detection signal $V_5$ provided by the fourth signal processing module 8. More particularly, said detection information includes the second detection signal $V_2$ provided by the second detection module 4 and based on the sixth detection signal $V_6$ provided by the fifth signal processing module 9.

In practice, it has been found that the detection arrangement, according to the invention, fully achieves the intended aim and objects.

The detection arrangement 1 can determine whether the electric line 100 is operating in a normal or an abnormal condition by acquiring a detection signal $V_2$ indicative the derivative of the line current I flowing along the electric line.

The detection arrangement 1 is thus capable of detecting quick changes in the operating condition of the electric line by exploiting the information provided by the high bandwidth signal $V_2$.

When the electric line 100 operates in a normal condition (time instants preceding the above-mentioned trigger instant $t_0$), the detection arrangement 1 behaves substantially as a traditional current detection arrangement. In this case, in fact, the line current I is subject to smooth variations about its nominal value and it can be monitored in a traditional way without particular issues.

When the electric line 100 instead operates in an abnormal condition (time instants following the above-mentioned trigger instant $t_0$), the detection arrangement 1 processes the detection signal $V_2$ indicative the derivative of the line current I to reconstruct the behaviour of the line current itself. The reconstruction of the line current I is conveniently carried out through simple and quick signal processing techniques (computation time is in the order of ms or lower), which allows a reliable detection of the line current I even if this latter is raising very fast, for example with magnitude variation rates in the order of 1000 A/ms.

The detection arrangement 1, according to the invention, therefore, allows an effective monitoring of the line current I in any operating conditions of the electric line 100.

According to some embodiments of the invention, the detection information provided by the detection arrangement 1 can be suitably exploited to dynamically select the threshold current $I_{TH}$ to be used as a reference to command the interruption of the line current I flowing along the electric line 100. In this way, it is possible to trip the protection device 110 operatively coupled to the electric line 100 in the most appropriate ways to ensure a reliable circuit protection and, at the same time, prevent unnecessary service interruptions.

The detection arrangement has a compact structure it is relatively easy to manufacture at industrial level, at competitive costs with currently available solutions of the state of the art.

**Claims**

1. A current detection arrangement for electric grids, **characterized in that** it comprises:

   - a first detection module (3) operatively coupled to an electric line (100) and configured to provide a first detection signal ($V_1$) indicative of a line current (I) flowing along said electric line;
   - a second detection module (4) operatively coupled to said electric line (100) and configured to provide a second detection signal ($V_2$) indicative of a variation rate (dI/dt) over time of said line current (I);
   - a first signal processing module (5) operatively coupled to said second detection module (4) to receive and process said second detection signal ($V_2$),

   wherein said first signal processing module (5) is configured to determine an operating condition of said electric line (100) based on said second detection signal ($V_2$), wherein said first signal processing module (5) is configured to provide control signals ($C_1$, $C_2$, $C_3$) for other signal processing modules, said control signals being generated depending on the determined operating condition of said electric line (100);

   - a second signal processing module (6) operatively coupled to said first detection module (3) to receive and process said first detection signal ($V_1$),

   wherein said second signal processing module (6) is configured to provide a third detection signal ($V_3$) tracking said first detection signal ($V_1$), if a normal operating condition of said electric line (100) is determined by said first signal processing module (5),
   wherein said second signal processing module (6) is configured to provide a third detection signal ($V_3$) having a constant value ($V_S$), if an abnormal operating condition of said electric line (100) is determined by said first signal processing module (5), said constant value ($V_S$) being indicative of a magnitude value ($I_0$) of said line current (I) measured at a trigger instant ($t_0$), at which said first signal processing module (5) has determined that said electric line operates in an abnormal condition;

   - a third signal processing module (7) operatively coupled to said second detection module (4) to receive and process said second detection signal ($V_2$),

   wherein said third signal processing module (7) is configured to provide a fourth detection signal ($V_4$) indicative of said line current (I), if an abnormal operating condition of said electric line (100) is determined by said first signal processing module (5),
   wherein said first signal processing module (5) is configured to provide said fourth detection signal ($V_4$) at time instants following said trigger instant ($t_0$),
   wherein said third signal processing module (7) is configured to obtain said fourth detection signal ($V_4$) by integrating over time said second detection signal ($V_2$);

   - a fourth signal processing module (8) operatively coupled to said second and third signal processing modules (6, 7) to receive and process said third and fourth detection signals ($V_3$, $V_4$),

   wherein said fourth signal processing module (8) is configured to provide a fifth detection signal ($V_5$) indicative of said line current (I),
   wherein said fourth signal processing module (8) is configured to obtain said fifth detection signal ($V_5$) by carrying out a weighted sum of said third and fourth detection signals ($V_3$, $V_4$).

2. Detection arrangement, according to claim 1, **characterized in that** said first detection module (3) comprises a first sensing block (31) including one or more Hall-effect sensors or one or more shunt resistors.

3. Detection arrangement, according to claim 2, **characterized in that** said first detection module (3) includes first filtering block (32) electrically connected in cascade to said first sensing block (31).

4.  Detection arrangement, according to one of the previous claims, **characterized in that** said second detection module (4) comprises a second sensing block (41) including at least a Rogowski coil.

5.  Detection arrangement, according to claim 4, **characterized in that** said first detection module (3) includes a second filtering block (42) electrically connected in cascade to said second sensing block (41).

6.  Detection arrangement, according to one of the previous claims, **characterized in that** said first signal processing module (5) is configured to:

    - compare the second detection signal ($V_2$) with a first threshold value ($V_A$) indicative of a predefined threshold variation rate ($dI/dt^*$) of said line current (I);
    - determine that said electric line (100) operates in a normal condition, if said second detection signal ($V_2$) does not exceed said first threshold value ($V_A$);
    - determine that said electric line (100) operates in an abnormal condition, if said second detection signal ($V_2$) exceeds said first threshold value ($V_A$).

7.  Detection arrangement, according to one of the previous claims, **characterized in that** it comprises a fifth signal processing module (9) operatively coupled to said second detection module (4) to receive and process said second detection signal ($V_2$),

    wherein said fifth signal processing module (9) is configured to provide a sixth detection signal ($V_6$) indicative of a variation rate ($dI/dt$) over time of said line current (I), if an abnormal operating condition of said electric line (100) are determined by said first signal processing module (5),
    wherein said fifth signal processing module (9) is configured to provide said sixth detection signal ($V_6$) at time instants following said trigger instant ($t_0$),
    wherein said third signal processing module (7) is configured to obtain said sixth detection signal ($V_4$) by amplifying said second detection signal ($V_2$).

8.  Detection arrangement, according to claim 7, **characterized in that** said fifth signal processing module (8) is operatively coupled to said second, third and sixth signal processing modules (6, 7, 9) to receive and process said third, fourth and sixth detection signals ($V_3$, $V_4$, $V_6$),

    wherein said fourth signal processing module (8) is configured to provide said fifth detection signal ($V_5$) indicative of said line current (I),
    wherein said fourth signal processing module (8) is configured to obtain said fifth detection signal ($V_5$) by carrying out a weighted sum of said third, fourth and sixth detection signals ($V_3$, $V_4$, $V_6$).

9.  Detection arrangement, according to one of the previous claims, **characterized in that** said electric line (100) is a DC electric line.

10. An electronic device (50) for electric grids including or operatively coupled to a detection arrangement (1), according to one of the previous claims.

11. Electronic device, according to claim 10, **characterized in that** it comprises a signal processing stage (10) operatively coupled to the fourth signal processing module (8) of said detection arrangement (1) to receive and process said fifth detection signal ($V_5$), wherein signal processing stage is configured to provide a trip signal (TP) for a protection device (110) operatively coupled to said electric line (100), said trip signal (TP) being generated based on said fifth detection signal ($V_5$).

12. Electronic device, according to one claim 11, **characterized in that** said signal processing stage (10) is configured to:

    - compare said fifth detection signal ($V_5$) with a second threshold value ($V_B$) indicative of a threshold current value ($I_{TH}$) set to command the interruption of a line current (I) flowing along said electric line (100);
    - provide said trip signal (T), if said fifth detection signal ($V_5$) exceeds said second threshold value ($V_B$).

13. Electronic device, according to one claim 12, **characterized in that** said threshold current value ($I_{TH}$) is predefined.

14. Electronic device, according to one claim 12, **characterized in that** said threshold current value ($I_{TH}$) is variable with the derivative (di/dt) of the line current (I) flowing along the electric line, said threshold current value ($I_{TH}$) being dynamically set based on detection information provided by said current detection arrangement (1).

15. A protection device for electric grids including or operatively coupled to an electronic device (50), according to one of the claims from 10 to 14.

16. A protection device, according to claim 15, **characterized in that** it is a circuit breaker of the solid-state type or hybrid type, which includes one or more solid-state switches.

FIG. 1

**FIG. 1A**

FIG. 2

FIG. 3

FIG. 4

FIG. 5

EP 4 783 393 A1

I ($V_4$)

$t_0$

t

**FIG. 6**

FIG. 7

**FIG. 8**

FIG. 9

EP 4 783 393 A1

FIG. 10

EP 4 783 393 A1

Europäisches
Patentamt

European
Patent Office

Office européen
des brevets

# EUROPEAN SEARCH REPORT

**Application Number**

EP 25 15 3461

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2024/175939 A1 (SPIEL PETER [DE] ET AL) 30 May 2024 (2024-05-30) * paragraphs [0040] - [0068]; figure 4 * ----- | 1-16 | INV. H02H3/44 H02H3/087 G01R31/52 |
| A | US 8 335 656 B2 (BERGER FRANK [DE]; MUETZEL TIMO [DE]; SIEMENS AG [DE]) 18 December 2012 (2012-12-18) * columns 3-6; figures 7, 8 * ----- | 1-16 | G01R19/00 H02H1/00 H02H3/00 |

**TECHNICAL FIELDS SEARCHED (IPC)**

H02H
G01R

The present search report has been drawn up for all claims

| Place of search | Date of completion of the search | Examiner |
|---|---|---|
| Munich | 7 August 2025 | Gomes Guerreiro, G |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 15 3461

This annex lists the patent family members relating to the patent documents cited in the above-mentioned European search report.
The members are as contained in the European Patent Office EDP file on
The European Patent Office is in no way liable for these particulars which are merely given for the purpose of information.

07-08-2025

| Patent document cited in search report | | Publication date | Patent family member(s) | | Publication date |
|---|---|---|---|---|---|
| US 2024175939 | A1 | 30-05-2024 | CN | 117795803 A | 29-03-2024 |
| | | | EP | 4131692 A1 | 08-02-2023 |
| | | | ES | 2967058 T3 | 25-04-2024 |
| | | | PL | 4131692 T3 | 26-02-2024 |
| | | | US | 2024175939 A1 | 30-05-2024 |
| | | | WO | 2023012361 A1 | 09-02-2023 |
| US 8335656 | B2 | 18-12-2012 | CN | 101842953 A | 22-09-2010 |
| | | | DE | 102007052963 A1 | 14-05-2009 |
| | | | US | 2010312505 A1 | 09-12-2010 |
| | | | WO | 2009056432 A1 | 07-05-2009 |

EPO FORM P0459

For more details about this annex : see Official Journal of the European Patent Office, No. 12/82